Europäisches Patentamt

European Patent Office

Office européen des brevets

(11) Publication number: **0 072 658**
**B1**

# EUROPEAN PATENT SPECIFICATION

(45) Date of publication of patent specification: **13.11.85**

(51) Int. Cl.⁴: **G 02 F 1/133, G 02 F 1/17**

(21) Application number: **82304204.9**

(22) Date of filing: **10.08.82**

(54) **Display device manufacture.**

(30) Priority: **18.08.81 GB 8125131**

(43) Date of publication of application:
**23.02.83 Bulletin 83/08**

(45) Publication of the grant of the patent:
**13.11.85 Bulletin 85/46**

(84) Designated Contracting States:
**BE DE FR IT NL**

(56) References cited:
**GB-A-2 009 991**

**RESEARCH DISCLOSURE No. 183, July 1979
L.F. COOLEY "A Finely Controlled Scriber for
Fragile Semiconductor Materials" pages 381 to
382, 18339**

(73) Proprietor: **ITT INDUSTRIES INC.**
**320 Park Avenue**
**New York, NY 10022 (US)**

(84) **BE FR IT NL**

(73) Proprietor: **Deutsche ITT Industries GmbH**
**Hans-Bunte-Strasse 19 Postfach 840**
**D-7800 Freiburg (DE)**

(84) **DE**

(72) Inventor: **Crossland, William Alden**
**15 School Lane**
**Harlow Essex (GB)**
Inventor: **Rosser, Paul John**
**120 Carters Mead Potter Street**
**Harlow Essex (GB)**

(74) Representative: **Laurence, Simon French et al**
**STC Patent Department Edinburgh Way**
**Harlow Essex CM20 2SH (GB)**

Courier Press, Leamington Spa, England.

## Description

This invention relates to the provision of electrically conductive tracks on substrates in the manufacture of liquid layer display devices such as liquid crystal or electro-chromic display devices.

Typically such tracks have in the past been made by suitable photolithographic etching of a transparent electrically conductive layer, for instance of indium tin oxide, deposited upon a glass substrate. We have found that for large display panels with increasing complexity of display requiring a higher density of conductive tracks the use of photolithographic techniques becomes increasingly difficult and costly and moreover the yield is reduced. These problems typically become significant for line widths of less than 20 microns between adjacent conductive tracks for panels larger than about 15 cm square.

According to the present invention there is provided a method of manufacturing a display device whose active medium is a liquid layer sandwiched between a pair of internally electroded substrates, wherein at least one of said substrates is made by a method that includes the step of forming a transparent electrically conductive layer on said substrate and characterised in that this step is followed either by the step of scribing channels through the thickness of that layer so as to produce a plurality of electrically isolated conductive tracks, or by the step of scribing channels through the thickness of an etch-resist layer covering the conductive layer and then etching through the thickness of the exposed regions of the conductive layer so as to produce a plurality of electrically isolated conductive tracks prior to the removal of the residual etch-resist.

With purely mechanical scribing three types of approach have been successfully tried. A diamond or tungsten carbide scribe has been used to scribe a fine line through the thickness of a film of indium tin oxide which was then thoroughly washed to remove any debris to leave a fine channel dividing the layer into two electrically isolated parts. An alternative type of approach involved scribing the fine line and then dipping the substrate in an etchant to remove the unwanted traces of scribed conductor material, while the third type of approach involved scribing the fine line in a layer of etch-resist covering the indium tin oxide layer and then etching after the manner used in conventional photolithography.

In the first and second types of approach it is possible to monitor the electrical properties of the coated substrate during the scribing so that, if a particular scribing operation fails to achieve complete electrical isolation of the two regions on either side of a scribed line, then the scribing can be repeated to remedy the defect.

In the preparation of electroded substrates for matrix displays many parallel lines are required and this lends itself readily to many lines being formed simultaneously by a comb-like array of scribes.

The scribing techniques may be used not only for delineating electrodes in a transparent conductor layers supported on glass substrates, but also those supported on plastics substrates.

There follows a description of specific embodiments of the invention in which lines have been delineated by scribing to produce an electrode pattern in a transparent conductor layer supported upon a glass or plastics substrate, such substrates being destined for use as components of a liquid crystal display.

In one range of tests a diamond scribe having a radius of approximately 50 μm was used to scribe lines on glass substrates coated with indium tin oxide of different thicknesses providing sheet resistivities in the range from 12 to 200 ohms per square. With this method it was found possible to scribe lines at speeds in the range of one to several centimetres per second with a scribe loading in the range of 0.05 to 1.0 newtons. This scribing provided electrically isolating channels in the range 5 to 10 μm wide between adjacent regions of the indium tin oxide showing an electrical isolation better than $10^{10}$ ohms.

In comparative tests investigating the scribing of indium tin oxide films having a sheet resistivity of 200 ohms per square supported upon polyester substrates it was found that the scribe typically needed a loading of 0.3 newtons to achieve complete electrical isolation, and the resulting channels were wider, typically being in the region of 50 μm wide.

In a further range of tests the mechanical scribing action was supplemented at least in part by electro-erosion using a direct current arc. For this purpose the diamond scribe was replaced with a tungsten carbide one having a radius of approximately 25 μm and a potential difference in the range from 0 to 25 volts was applied between the indium tin oxide and the scribe. It was found that, for instance, with a relatively thick indium tin oxide layer providing a sheet resistivity of 10 ohms per square, 15 volts was sufficient to maintain an arc and produce a channel approximately 50 μm wide. Microscopic examination of this channel revealed it to be composed of a series of arc craters approximately 10 μm in diameter. The current required whilst the arc is running, and while a channel is being scribed is small, being typically less than 5 mA. Initially, when the scribing tool is placed in contact with an unpunctured region of the indium tin oxide film, a higher current, typically of up to 250 mA, is taken before the arc strikes. It is believed that this current is required to produce enough Joule heating to achieve thermal volatilisation sufficient to initiate the arc. It may be possible to avoid this requirement for such a high starting current by initiating the arc with the scribe out of contact with the indium tin oxide.

In comparison with the pure mechanical scribing, it is found that the use of direct current arc assisted scribing makes the cutting easier in terms of scribe loading and cutting speed. However, the channels produced are wider. This can be used to advantage for instance by using a "chisel-shaped" scribing tool to cut channels up to 1 mm wide such as may be required for instance at the edges of a substrate in regions to which external electrical connection is being made.

When using a direct current arc to assist the cutting action of mechanical scribing it is necessary to make a direct electrical connection with the indium tin oxide, and there is a dependence of the arc upon the resistance of the conductive path in the oxide layer between this connection and the scribe. In some circumstances, particular when using a plurality of scribes arranged as a "comb", it is difficult to achieve adequate control of the arcs without having to move the connection during the scribing. This disadvantage can be overcome by using an alternating current arc and by relying upon capacitative coupling between the different parts of the indium tin oxide layer and between it and its surroundings to avoid the necessity for there to be any direct electrical connection with that layer.

Tests to verify the possibility of using an alternating current arc were made using a Tesla coil of the type used for leak testing in vacuum systems (Edwards High Vacuum, H. F. Tester, Model T2). The frequency of such a coil was found to be high enough to avoid any need for a direct connection to be made with the indium tin oxide layer, but the voltage developed, probably many kilo volts, is believed to be much greater than necessary. Sustained arcing was achieved by maintaining the scribe just out of contact with the oxide layer, and channels of between 50 and 125 μm width were produced. Microscopic examination of these channels revealed them to be made up of an "interwoven" lot of arc tracks. These tracks spread away from under the scribe as a result of the excessively high field, and it was found that several passes of the scribe were necessary to ensure complete electrical isolation due to the meandering of the arc track upon a microscopic scale.

It will be clearly appreciated that this Tesla coil is not suggested as an ideal power source for alternating current arc assisted scribing. However, the high voltage of a Tesla coil powered scribe has been found useful for cleaning up imperfectly scribed tracks by burning out any residual filamentry tracks of indium tin oxide left between adjacent conductor tracks defined by the scribing of an intervening channel. It is also found possible to use the Tesla coil powered scribe for systematic widening of existing scribed channels by applying the scribe to the channels for longer periods. By this means channels having a width of less than 25 μm have been widened to greater than 125 μm.

In an attempt to achieve better control over the arcing conditions with alternativing current assisted scribing a 60 watt radio frequency transmitter was substituted for the Tesla coil. The power actually available was very much less than the rated power, and the scribe was connected to the transmitter aerial socket via an air-spaced transformer without any attempt being made to achieve matching impedance or measuring actual power delivered. With this arrangement it was found that channels could be scribed by arc erosion with the tip of the scribe in contact with the surface. Channels having widths down to about 50 μm were also cut using this power source and a "comb" structure scriber with 20 tungsten points each with approximately 25 μm radius. In this instance the power supply fed the 20 points in parallel and repetitive scribing was found necessary to make good the defects occasioned by occasional extinguishing of various of the arcs. It is fully expected that these problems will be overcome by some regulation of the current flow through the individual arcs and by matching the power level more closely to the requirements.

Once the substrate has been provided with its required pattern of electrodes, these electrodes may be covered, if desired, with an electrically insulating transparent layer to prevent direct electrical contact between the liquid display medium and the electrodes. Such a layer may be for instance a layer of silica deposited by chemical vapour reaction of for instance silane with oxygen. The substrate is then assembled with another substrate provided with a co-operating pattern of electrodes either by the same method or by some other method, and the two substrates are secured together with an edge seal to form an envelope for the liquid crystal layer. The resulting cell is typically filled with its liquid crystal medium in conventional manner by evacuating the cell and back filling it through an aperture formed either by a hole in one of the substrates or by an interruption in the edge seal. This aperture is then hermetically sealed. Electrical connection with the cell is then made by way of the portions of the electrodes outwardly from beyond the region of the edge seal.

**Claims**

1. A method of manufacturing a display device whose active medium is a liquid layer sandwiched between a pair of internally electroded substrates, wherein at least one of said substrates is made by a method that includes the step of forming a transparent electrically conductive layer on said substrate, characterised in that this step is followed either by the step of scribing channels through the thickness of that layer so as to produce a plurality of electrically isolated conductive tracks, or by the step of scribing channels through the thickness of an etch-resist layer covering the conductive layer and then etching through the thickness of the exposed regions of the conductive layer so as to produce a plurality of electrically isolated conductive tracks prior to the removal of the residual etch-resist.

2. A method as claimed in claim 1, wherein said channels are scribed mechanically.

3. A method as claimed in claim 1, wherein said channels are scribed at least in part by electro-erosion.

4. A method as claimed in claim 3, wherein the electro-erosion is powered by a direct current power supply.

5. A method as claimed in claim 3, wherein the electro-erosion is powered by an alternating current supply.

6. A method as claimed in any preceding claim, wherein a comb structure is employed for the simultaneous scribing of a plurality of parallel channels defining all or part of said plurality of tracks.

7. A method as claimed in any preceding claim, wherein the scribing is such as to produce two or more conductive tracks separated by channels that are less than 20 µm in width.

8. A method as claimed in any preceding claim, wherein said transparent electrically conductive layer is applied to a glass substrate.

9. A method as claimed in any claim of claims 1 to 7, wherein said transparent electrically conductive layer is applied to a plastics substrate.

## Revendications

1. Méthode de fabrication d'un dispositif de visualisation dont le fluide actif est une couche liquide prise en sandwich entre une paire de substrats portant à l'intérieur des électrodes, où au moins l'un de ces substrats est fabriqué selon une méthode incluant une étape de formation d'une couche transparente électriquement conductrice sur ledit substrat, caractérisée en ce que cette étape est suivie soit par une opération de gravure de canaux dans l'épaisseur de cette couche de manière à obtenir une pluralité de pistes conductrices électriquement isolées, ou par une opération de gravure de canaux dans l'épaisseur d'une couche résistant aux produits d'attaque couvrant la couche conductrice, puis par attaque chimique dans l'épaisseur des régions exposées de la couche conductrice, de manière à obtenir une pluralité de pistes conductrices électriquement isolées avant l'élimination du résidu de la couche résistant à l'attaque.

2. Méthode selon la revendication 1, caractérisée en ce que lesdits canaux sont gravés mécaniquement.

3. Méthode selon la revendication 1, caractérisée en ce que lesdits canaux sont gravés partiellement au moins par électro-érosion.

4. Méthode selon la revendication 3, caractérisée en ce que le système d'électro-érosion est alimenté par une alimentation en courant continu.

5. Méthode selon la revendication 3, caractérisée en ce que le système d'électro-érosion est alimenté par une alimentation en courant alternatif.

6. Méthode selon l'une des revendications précédentes, caractérisée en ce qu'une structure en peigne est utilisée pour la gravure simultanée d'une pluralité de canaux parallèles définissant tout ou partie de ladite pluralité de pistes.

7. Méthode selon l'une des revendications précédentes, caractérisée en ce que la gravure est telle qu'elle produit deux ou plusieurs pistes conductrices séparées par des canaux d'une largeur inférieure à 25 µm.

8. Méthode selon l'une des revendications précédentes, caractérisée en ce ladite couche transparente électriquement conductrice est appliquée sur un substrat de verre.

9. Méthode selon l'une des revendications 1 à 7, caractérisée en ce ladite couche transparente électriquement conductrice est appliquée sur un substrat en matière plastique.

## Patentansprüche

1. Verfahren zum Herstellen einer Anzeigevorrichtung, deren aktives Medium aus einer flüssigen Schicht zwischen einem Paar von intern mit Elektroden versehenen Substraten besteht, wobei wenigstens eines der beiden Substrate mit einer transparenten, elektrisch leitenden Schicht versehen wird, dadurch gekennzeichnet, daß dann entweder Kanäle durch die gesamte Dicke dieser Schicht angerissen werden, um eine Vielzahl von elektrisch isolierten, leitenden Spuren zu erhalten, oder Kanäle durch die gesamte Dicke einer die elektrisch leitende Schicht abdekkenden ätzfesten Schicht angerissen werden und danach durch die gesamte Dicke der freigelegten Bereiche der elektrisch leitenden Schicht geätzt wird, um eine Vielzahl von elektrisch isolierten, leitenden Spuren vor dem Entfernen der übrig gebliebenen ätzfesten Schicht zu erhalten.

2. Verfahren nach Anspruch 1, dadurch gekennzeichnet, daß die Kanäle mechanisch angerissen werden.

3. Verfahren nach Anspruch 1, dadurch gekennzeichnet, daß die Kanäle zumindest teilweise durch Elektroerosion erzeugt werden.

4. Verfahren nach Anspruch 3, dadurch gekennzeichnet, daß zur Elektroerosion Gleichstrom verwendet wird.

5. Verfahren nach Anspruch 3, dadurch gekennzeichnet, daß zur Elektroerosion Wechselstrom verwendet wird.

6. Verfahren nach einem der vorhergehenden Ansprüche, dadurch gekennzeichnet, daß eine Kammstruktur verwendet wird, um gleichzeitig eine Vielzahl von parallelen Kanälen, die alle oder einen Teil der Vielzahl der Spuren definieren, anzureißen.

7. Verfahren nach einem der vorhergehenden Ansprüche, dadurch gekennzeichnet, daß zwei oder mehr leitende Spuren erzeugt werden, die durch Kanäle mit einer geringeren Breite als 20 µm getrennt sind.

8. Verfahren nach einem der vorhergehenden Ansprüche, dadurch gekennzeichnet, daß die transparente, elektrisch leitende Schicht auf ein Glassubstrat aufgebracht ist.

9. Verfahren nach einem der Ansprüche 1 bis 7, dadurch gekennzeichnet, daß die transparente, elektrisch leitende Schicht auf ein Plastiksubstrat aufgebracht ist.